(19) Europäisches Patentamt
European Patent Office
Office européen des brevets

(11) **EP 4 254 796 A2**

(12) **DEMANDE DE BREVET EUROPEEN**

(43) Date de publication:
**04.10.2023 Bulletin 2023/40**

(21) Numéro de dépôt: **23187802.6**

(22) Date de dépôt: **12.12.2018**

(51) Classification Internationale des Brevets (IPC):
*H03K 17/082* (2006.01)

(52) Classification Coopérative des Brevets (CPC):
**H03K 17/0822;** H03K 2217/0027; H03K 2217/0072

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **18.12.2017 FR 1762379**

(62) Numéro(s) de document de la (des) demande(s)
initiale(s) en application de l'article 76 CBE:
**18819090.4 / 3 729 649**

(71) Demandeur: **Safran Electronics & Defense
75015 Paris (FR)**

(72) Inventeurs:
• **MELINE, Olivier
77550 MOISSY-CRAMAYEL (FR)**
• **GUILLOT, François
77550 MOISSY-CRAMAYEL (FR)**

(74) Mandataire: **Lavaud, Thomas et al
Cabinet Boettcher
5, rue de Vienne
75008 Paris (FR)**

Remarques:
Cette demande a été déposée le 26.07.2023 comme
demande divisionnaire de la demande mentionnée
sous le code INID 62.

(54) **CIRCUIT DE COMMUTATION**

(57) Circuit de commutation comportant un transistor (23) et un composant de pilotage destiné à la fois à commander le transistor et à limiter un courant d'alimentation (Ia) fourni à une charge (22), le composant de pilotage étant agencé pour recevoir une tension de commande ($V_H$) et pour :
- lorsque la tension de commande ($V_H$) est un signal de déconnexion, générer une tension de pilotage ($V_p$) qui commande le transistor dans un état bloqué ;
- lorsque la tension de commande ($V_H$) est un signal de connexion et que le courant d'alimentation (Ia) ne peut pas atteindre un seuil de courant prédéfini, générer une tension de pilotage ($V_p$) qui commande le transistor en régime saturé ;
- lorsque la tension de commande ($V_H$) est un signal de connexion et que le courant d'alimentation (Ia) peut atteindre le seuil de courant prédéfini, générer une tension de pilotage ($V_p$) qui commande le transistor en régime linéaire, de sorte que le courant d'alimentation soit régulé pour ne pas dépasser le seuil de courant prédéfini.

Fig. 3

**Description**

L'invention concerne le domaine des circuits de commutation destinés à commuter à une masse électrique un point froid d'une charge dont un point chaud est relié à un réseau d'alimentation.

ARRIERE PLAN DE L'INVENTION

Certains calculateurs, notamment dans le domaine de l'aéronautique, mettent en œuvre une fonction appelée DSO (pour *Discret Switch Output,* en anglais). La fonction DSO permet, depuis une sortie discrète du calculateur, de commuter à une masse électrique un point froid d'une charge dont un point chaud est relié à un réseau d'alimentation.

La charge est un équipement à alimenter, par exemple une électrovanne. Le réseau d'alimentation fournit une tension d'alimentation, qui est par exemple une tension continue égale à 28VDC.

Le calculateur comporte ainsi un circuit de commutation relié à la sortie discrète et agencé pour sélectivement mettre la sortie discrète en circuit ouvert ou relier la sortie discrète à la masse électrique.

La fonction DSO est généralement associée à une fonction de limitation du courant d'alimentation fourni à la charge. La fonction de limitation est mise en œuvre par un circuit de limitation qui assure que le courant d'alimentation ne dépasse pas un seuil de courant prédéfini.

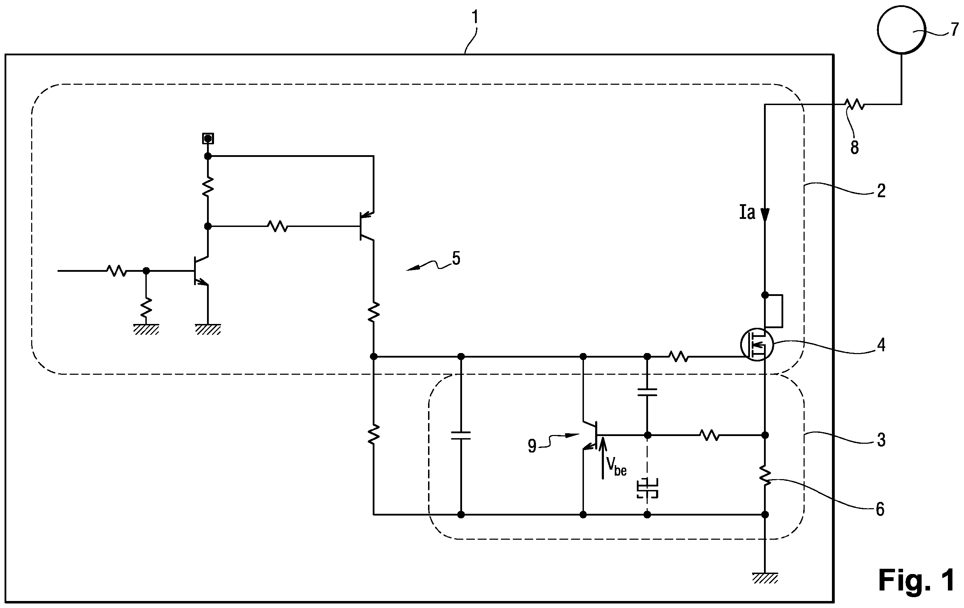

Un calculateur 1, intégrant un circuit de commutation 2 et un circuit de limitation 3 de l'art antérieur, est représenté sur la figure 1.

Le circuit de commutation 2 comporte un transistor 4 de type MOSFET et des composants de pilotage 5 qui commandent le transistor 4. Le circuit de limitation 3 comporte une résistance de mesure 6, un shunt en l'occurrence, aux bornes desquelles s'établit une tension de mesure proportionnelle au courant d'alimentation Ia fourni par le réseau d'alimentation 7 à la charge 8.

Le principal inconvénient de cette première solution est que le seuil de courant prédéfini est très dépendant du transistor 9 qui réalise la limitation de courant, et notamment des variations en température des caractéristiques dudit transistor 9. Le seuil de courant prédéfini est donc maîtrisé en général avec une précision de l'ordre de +/-50%, ce qui peut être pénalisant pour certaines applications.

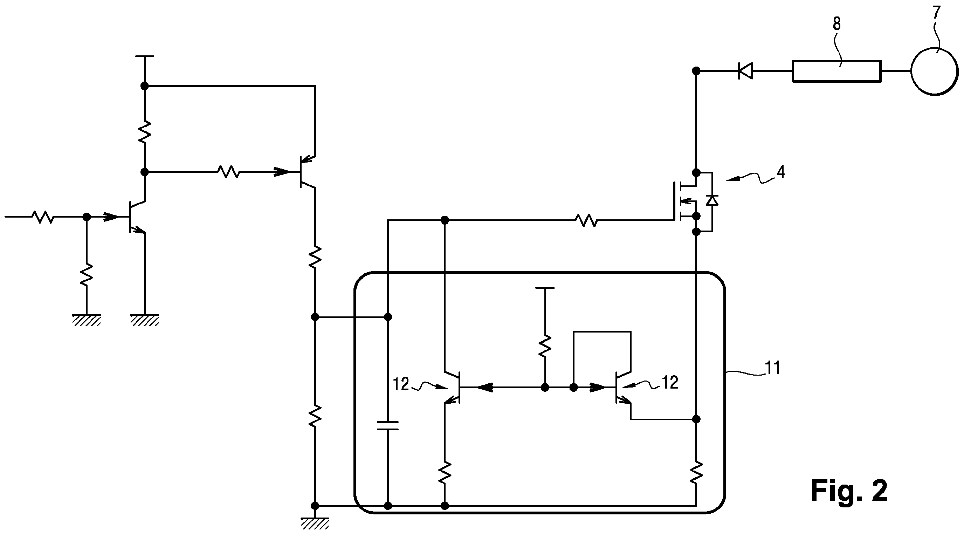

On a envisagé, en référence à la figure 2, d'améliorer la précision de la limitation en utilisant un montage 11 de type « miroir de courant ». La précision obtenue est alors de l'ordre de +/-25%. Cette deuxième solution nécessite l'utilisation de deux transistors 12 appariés montés dans un même boîtier. Les composants utilisés sont donc moins classiques et sont sujets aux obsolescences. La deuxième solution est par ailleurs relativement complexe à concevoir et à fabriquer.

OBJET DE L'INVENTION

L'invention a pour objet de simplifier le circuit de commutation et le circuit de limitation, et d'améliorer la précision de la limitation.

RESUME DE L'INVENTION

En vue de la réalisation de ce but, on propose un circuit de commutation destiné à commuter à une masse électrique un point froid d'une charge dont un point chaud est relié à un réseau d'alimentation, le circuit de commutation comportant un transistor monté entre le point froid et la masse électrique, une résistance de mesure montée entre le transistor et la masse électrique, et un composant de pilotage destiné à la fois à commander le transistor et à limiter un courant d'alimentation fourni à la charge par le réseau d'alimentation, le composant de pilotage étant agencé pour recevoir une tension de commande formant un signal de connexion ou un signal de déconnexion du point froid et de la masse électrique, et pour :

- lorsque la tension de commande est un signal de déconnexion, générer une tension de pilotage qui commande le transistor dans un état bloqué ;
- lorsque la tension de commande est un signal de connexion et que le courant d'alimentation ne peut pas atteindre un seuil de courant prédéfini, générer une tension de pilotage qui commande le transistor en régime saturé ;
- lorsque la tension de commande est un signal de connexion et que le courant d'alimentation peut atteindre le seuil de courant prédéfini, générer une tension de pilotage qui commande le transistor en régime linéaire, de sorte que le courant d'alimentation soit régulé pour ne pas dépasser le seuil de courant prédéfini.

Dans le circuit de commutation selon l'invention, un unique composant de pilotage commande le transistor qui réalise la commutation, et limite le courant d'alimentation fourni à la charge. Le circuit de commutation selon l'invention est donc beaucoup plus simple que les circuits de l'art antérieur.

De plus, dans le circuit de commutation selon l'invention, la précision du seuil de courant prédéfini dépend principalement de la précision de la tension de commande et de la résistance de mesure, qui sont deux paramètres facilement maîtrisables. On peut ainsi obtenir une erreur relative sur le seuil de courant prédéfini de quelques %.

On propose en outre un calculateur comprenant un circuit de commutation tel que celui qui vient d'être décrit et une sortie discrète reliée au circuit de commutation.

D'autres caractéristiques et avantages de l'invention ressortiront à la lecture de la description qui suit de modes de réalisation particuliers non limitatifs de l'invention.

BREVE DESCRIPTION DES DESSINS

Il sera fait référence aux dessins annexés, parmi lesquels :

- la figure 1 représente un circuit de commutation et un circuit de limitation selon une première solution de l'art antérieur ;
- la figure 2 représente un circuit de commutation et un circuit de limitation selon une deuxième solution de l'art antérieur ;
- la figure 3 représente un circuit de commutation selon un premier mode de réalisation de l'invention ;
- la figure 4 représente le circuit de commutation selon le premier mode de réalisation de l'invention, associé à des circuits de surveillance réalisant diverses fonctions de surveillance ;
- la figure 5 représente un circuit de commutation selon un deuxième mode de réalisation de l'invention ;
- la figure 6 représente un premier générateur de signal par modulation de largeur d'impulsion ;
- la figure 7 représente un circuit de surveillance d'un composant de protection contre la foudre ;
- la figure 8 représente un deuxième générateur de signal par modulation de largeur d'impulsion ;
- la figure 9 comporte trois graphiques illustrant le fonctionnement du circuit de surveillance du composant de protection contre la foudre.

DESCRIPTION DETAILLEE DE L'INVENTION

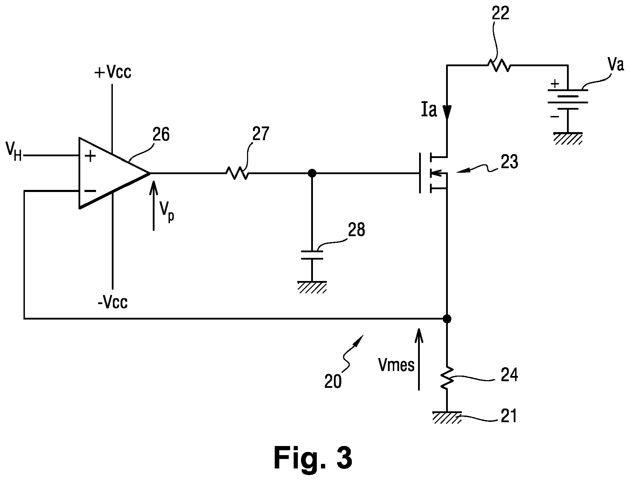

On décrit tout d'abord, en référence à la figure 3, le principe d'un circuit de commutation selon un premier mode de réalisation de l'invention 20.

Le circuit de commutation 20 est monté dans un calculateur qui est intégré dans un système embarqué d'un aéronef.

Le circuit de commutation 20 remplit deux fonctions qui sont, comme on vient de le voir, remplies habituellement par deux circuits distincts.

La première fonction est une fonction de commutation. Le circuit de commutation 20 est destiné à commuter à une masse électrique 21 un point froid d'une charge 22 dont un point chaud est relié à un réseau d'alimentation.

Ici, par « point chaud » d'un composant comprenant deux bornes, on entend la borne qui est au potentiel le plus haut, et par « point froid », on entend la borne qui est au potentiel le plus bas.

La deuxième fonction est une fonction de limitation. Le circuit de commutation assure qu'un courant d'alimentation Ia circulant au travers de la charge 22 ne dépasse pas un seuil de courant prédéfini.

La charge 22 est ici symbolisée par une résistance. Le réseau d'alimentation fournit à la charge 22 le courant d'alimentation Ia, sous une tension d'alimentation continue Va.

Le circuit de commutation 20 comporte tout d'abord un transistor 23 monté entre le point froid de la charge 22 et la masse électrique 21. Le transistor 23 est ici un transistor de puissance de type MOSFET.

Le circuit de commutation 20 comporte de plus une résistance de mesure 24, un *shunt* en l'occurrence. La résistance de mesure 24 est montée entre le transistor 23 et la masse électrique 21. Un point chaud de la résistance de mesure 24 est relié à une source du transistor 23. La tension aux bornes de la résistance de mesure 24 est une tension de mesure Vmes proportionnelle au courant d'alimentation Ia.

Le circuit de commutation 20 comporte de plus un composant de pilotage destiné à la fois à commander le transistor 23 et à limiter le courant d'alimentation Ia. Le composant de pilotage est ici un amplificateur opérationnel 26.

Une entrée inverseuse de l'amplificateur opérationnel 26 est reliée au point chaud de la résistance de mesure 24.

Une tension de commande $V_H$ est appliquée sur une entrée non inverseuse de l'amplificateur opérationnel 26.

La tension de commande $V_H$ forme un signal de connexion ou un signal de déconnexion du point froid de la charge 22 et de la masse électrique.

Une sortie de l'amplificateur opérationnel 26 est connectée à une grille du transistor 23 via une résistance 27 et une capacité 28.

Une tension de pilotage $V_p$ du transistor 23 est générée sur la sortie de l'amplificateur opérationnel 26.

Le circuit de commutation 20 fonctionne selon trois modes de fonctionnement.

Le premier mode de fonctionnement est utilisé lorsque la charge 22 ne doit pas être alimentée. Dans ce cas, l'amplificateur opérationnel 26 reçoit une tension de commande $V_H$ négative sur l'entrée non inverseuse. La tension de commande $V_H$ négative est un signal de déconnexion.

L'amplificateur opérationnel 26 fonctionne en comparateur.

Comme l'entrée inverseuse, qui est connectée au point chaud de la résistance de mesure 24, ne peut être négative quel que soit l'état du transistor 23, l'amplificateur opérationnel 26 est amené en régime de saturation négative.

La tension de pilotage $V_p$ en sortie de l'amplificateur opérationnel 26 est donc une tension de saturation négative, proche de -Vcc, où +Vcc est la tension d'alimentation positive de l'amplificateur opérationnel 26. Du fait de la tension de saturation négative appliquée sur la grille du transistor 23, le transistor 23 se trouve dans un état bloqué (ouvert). Le courant d'alimentation Ia circulant au travers de la charge 22 est donc nul.

Lorsqu'il convient d'alimenter la charge 22, l'amplificateur opérationnel 26 reçoit une tension de commande $V_H$ positive sur l'entrée non inverseuse. La tension de commande $V_H$ positive est un signal de connexion.

La tension de commande $V_H$ positive est fixée à : $V_H = \text{Ilim.Rmes}$,

où Rmes est la valeur de la résistance de mesure 24, et
où Ilim est la valeur du seuil de courant prédéfini.

L'amplificateur opérationnel 26 fait en sorte que le potentiel de l'entrée inverseuse rejoigne la tension de commande $V_H$ appliquée sur l'entrée non inverseuse. La tension de pilotage $V_p$ en sortie de l'amplificateur opérationnel 26 va donc augmenter jusqu'à la mise en conduction du transistor 23. Le transistor 23 autorise donc le passage du courant d'alimentation Ia à travers la charge 22 et à travers la résistance de mesure 24.

Deux cas sont alors possibles.

Lorsque l'impédance de la charge 22 est telle, au vu de la tension d'alimentation Va, que le courant d'alimentation Ia ne peut atteindre le seuil de courant prédéfini (même avec le transistor 23 en régime saturé), la tension de l'entrée inverseuse ne peut atteindre la valeur de la tension de commande $V_H$. La tension de pilotage $V_p$ en sortie de l'amplificateur opérationnel 26 augmente alors jusqu'à atteindre une tension de saturation positive proche de +Vcc. L'amplificateur opérationnel 26 se trouve alors dans un régime de saturation positive. Le transistor 23 se trouve en régime saturé. Le circuit de commutation 20 se trouve dans un état « fermé » correspondant à un deuxième mode de fonctionnement.

Par contre, lorsque l'impédance de la charge 22 est telle, au vu de la tension d'alimentation Va, que le courant d'alimentation Ia peut atteindre et même dépasser le seuil de courant prédéfini, la tension de pilotage $V_p$ en sortie de l'amplificateur opérationnel 26 augmente uniquement jusqu'à une tension de conduction. La tension de conduction correspond à une mise en conduction du transistor 23, grâce à laquelle le courant d'alimentation Ia atteint le seuil de courant prédéfini. La tension de mesure Vmes aux bornes de la résistance de mesure 24, et donc la tension de l'entrée inverseuse de l'amplificateur opérationnel 26, atteignent la valeur de la tension de commande $V_H$. L'amplificateur opérationnel 26 ne se trouve plus dans le régime de saturation positive mais en régime linéaire. Le transistor 23 se trouve en régime linéaire. Le circuit de commutation 20 se trouve dans un troisième mode de fonctionnement. Dans le troisième mode de fonctionnement, la tension de mesure Vmes est asservie sur la tension de commande $V_H$. Le courant d'alimentation Ia est ainsi régulé pour ne pas dépasser le seuil de courant prédéfini Ilim :

$$\text{Ilim} = V_H / \text{Rmes}.$$

Le circuit de commutation 20 met donc en œuvre une boucle de régulation qui régule le courant d'alimentation Ia.

Le circuit de commutation 20 présente un certain nombre d'avantages par rapport à l'art antérieur.

La précision du seuil de courant prédéfini dépend principalement de la précision de la tension de commande $V_H$ et de la valeur de résistance Rmes de la résistance de mesure 24, qui sont deux paramètres facilement maîtrisables. On peut ainsi obtenir une erreur relative sur le seuil de courant prédéfini de quelques %.

De plus, dans le circuit de limitation 3 visible sur la figure 1, la valeur de la résistance de mesure 6 est contrainte par la relation Vbe/Ilim. La valeur requise de la résistance de mesure 6 peut donc être relativement importante et générer une chute de tension trop importante lorsque le transistor 23 est dans l'état fermé.

Dans le circuit de commutation 20, la valeur de la résistance de mesure 24 peut être réduite, pour une même valeur de seuil de courant prédéfini, en diminuant la valeur de la tension de commande $V_H$.

Par ailleurs, comme le seuil de courant prédéfini est mieux maîtrisé, le dimensionnement en puissance du circuit de commutation 20 peut être optimisé. Le courant maximal à prendre en compte, en mode de limitation, peut en effet être réduit de l'ordre de 50% par rapport au schéma de la figure 1.

De plus, le circuit de commutation 20, qui est très simple, remplit à la fois la fonction de commutation et la fonction de limitation. On simplifie ainsi de manière importante le calculateur qui remplit ces fonctions.

En outre, les composants utilisés sont des composants classiques et génériques, qui permettent de garantir un approvisionnement facile, sans risque d'obsolescence.

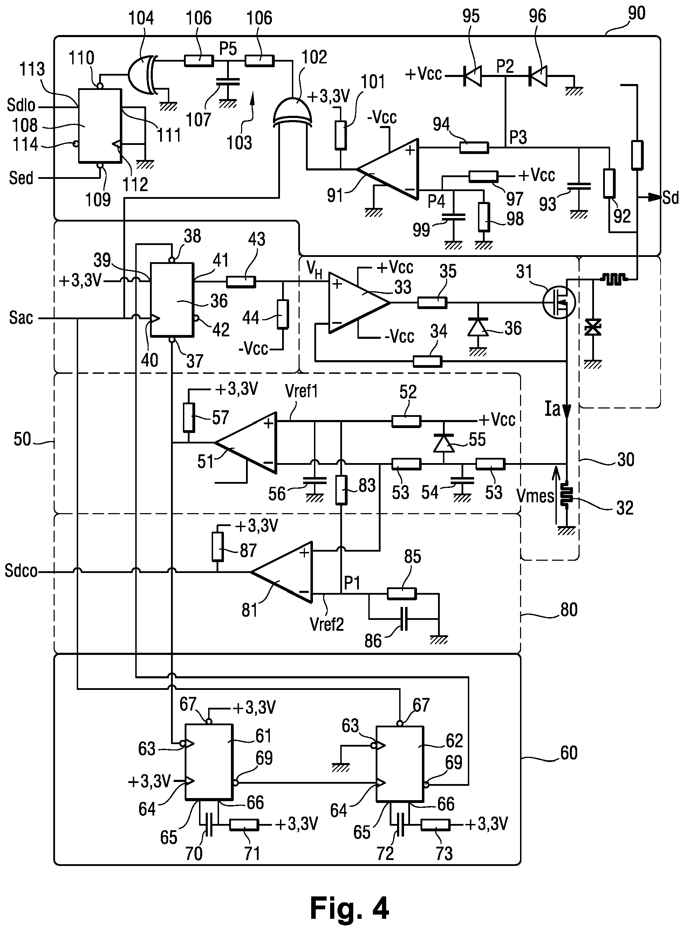

On décrit maintenant, en référence à la figure 4, un exemple réel de mise en oeuvre, dans un calculateur, d'un circuit de commutation 30 selon le premier mode de réalisation de l'invention.

Le calculateur comporte une sortie discrète Sd destinée à être reliée au point froid de la charge à alimenter.

Le circuit de commutation 30 est relié à la sortie discrète Sd.

Le circuit de commutation 30 comporte donc un transistor 31 de type MOSFET, une résistance de mesure 32 et un premier amplificateur opérationnel 33.

L'entrée inverseuse du premier amplificateur opérationnel 33 est reliée au point chaud de la résistance de mesure 32 via une résistance 34. La sortie du premier amplificateur opérationnel 33 est connectée à la grille du transistor 31 via une résistance 35 et une diode 36. Le premier amplificateur opérationnel 33 est alimenté par une tension d'alimentation positive +Vcc et par une tension d'alimentation négative -Vcc.

Le circuit de commutation 30 et, plus précisément, le premier amplificateur opérationnel 33, sont pilotés via une première bascule D 36. La première bascule D 36 comporte une entrée Reset 37, une entrée Set 38, une entrée Data 39, une entrée CLK 40, une sortie Q 41 et une sortie $\overline{Q}$ 42.

La sortie Q 41 est reliée, via une résistance 43, à l'entrée non inverseuse du premier amplificateur opérationnel 33.

Une tension de +3,3V, soit un état haut, est appliquée continuellement sur l'entrée Data 39. La sortie $\overline{Q}$ 42 n'est pas connectée.

Lorsque la fonction de commutation, c'est à dire l'alimentation de la charge, n'est pas activée, un signal d'activation de commutation Sac est à l'état bas. Le signal d'activation de commutation Sac est appliqué sur l'entrée CLK 40. La sortie Q 41 est à l'état bas.

La tension d'alimentation négative -Vcc produit, via la résistance 44, une tension de commande $V_H$ négative sur l'entrée non inverseuse du premier amplificateur opérationnel 33. La tension de commande $V_H$ négative est un signal de déconnexion. Le circuit de commutation 30 se trouve dans le premier mode de fonctionnement.

Lorsque la fonction de commutation est activée, le signal d'activation de commutation Sac appliqué sur l'entrée CLK 40 est à l'état haut. La sortie Q 41 passe à l'état haut.

Une tension de commande $V_H$ positive est alors appliquée sur l'entrée non inverseuse du premier amplificateur opérationnel 33. La tension de commande $V_H$ positive est un signal de connexion. Le circuit de commutation 30 se trouve dans le deuxième mode de fonctionnement ou dans le troisième mode de fonctionnement, selon l'impédance de la charge et la valeur de la tension d'alimentation qui alimente la charge.

Le calculateur comporte de plus un circuit de désarmement 50 qui commande le transistor 31 dans l'état bloqué en cas de surintensité dans la charge. Le circuit de désarmement 50 comporte un deuxième amplificateur opérationnel 51.

Une entrée non inverseuse du deuxième amplificateur opérationnel 51 est reliée à la tension d'alimentation positive +Vcc via une résistance 52 et une capacité 56.

Une entrée inverseuse du deuxième amplificateur opérationnel 51 est reliée au point chaud de la résistance de mesure 32 via deux résistances 53 et une capacité 54. Une diode 55 est connectée entre les deux résistances 53 et à un point chaud de la résistance 52.

Une sortie du deuxième amplificateur opérationnel 51 est reliée à une tension de +3,3V via une résistance 57.

La sortie du deuxième amplificateur opérationnel 51 est aussi reliée à l'entrée RESET 37 de la première bascule D 36.

Le deuxième amplificateur opérationnel 51 compare la tension de mesure Vmes aux bornes de la résistance de mesure 32 avec une première tension de référence Vref1 fixe et positive appliquée sur l'entrée non inverseuse.

Lorsque la tension de mesure Vmes est supérieure à la première tension de référence Vref1, ce qui indique une surintensité, c'est-à-dire une valeur trop importante et donc suspecte du courant d'alimentation Ia, la sortie du deuxième amplificateur opérationnel 51 passe dans un état bas. L'entrée RESET 37 de la première bascule D 36 passe elle aussi dans un état bas, ce qui fait passer la sortie Q 41 dans un état bas. Le circuit de commutation 30 se trouve alors dans le premier mode de fonctionnement, et la charge n'est alors plus alimentée.

Le calculateur comporte de plus un circuit de réarmement automatique 60. Le réarmement automatique fait suite à un désarmement provoqué par le circuit de désarmement 50. Le circuit de réarmement automatique 60 comporte un premier multivibrateur monostable 61 et un deuxième multivibrateur monostable 62. Le premier multivibrateur monostable 61 et le deuxième multivibrateur monostable 62 sont ici intégrés dans un même composant.

Le premier multivibrateur monostable 61 et le deuxième multivibrateur monostable 62 comportent chacun une entrée A 63, une entrée B 64, une entrée Cext 65, une entrée Rext 66, une entrée $\overline{CL}$ 67, une sortie Q (non connectée et non représentée) et une sortie $\overline{Q}$ 69.

L'entrée A 63 du premier multivibrateur monostable 61 est reliée à l'entrée RESET 37 de la première bascule D 36. Une tension de +3,3V, soit un état haut, est appliquée continuellement sur l'entrée B 64 et sur l'entrée $\overline{CL}$ 67. Une capacité 70 est connectée entre l'entrée Cext 65 et l'entrée Rext 66. Une tension de +3,3V est appliquée sur l'entrée Rext 66 via une résistance 71, et sur l'entrée Cext 65 via la résistance 71 et la capacité 70.

L'entrée A 63 du deuxième multivibrateur monostable 62 est reliée à la masse électrique. L'entrée B 64 est reliée à la sortie $\overline{Q}$ 69 du premier multivibrateur monostable 61. Une capacité 72 est connectée entre l'entrée Cext 65 et l'entrée Rext 66. Une tension de +3,3V est appliquée sur l'entrée Rext 66 via une résistance 73, et sur l'entrée Cext 65 via la résistance 72 et la capacité 73. Le signal d'activation de commutation Sac est appliqué sur l'entrée $\overline{CL}$ 67. La sortie $\overline{Q}$ 69 est connectée à l'entrée SET 38 de la première bascule D 36.

Suite à un désarmement provoqué par le circuit de désarmement 50, le premier multivibrateur monostable 61 applique un temps de blocage avant un réarmement automatique, et le deuxième multivibrateur monostable 62, après le temps de blocage, génère une transition vers un état haut sur sa sortie $\overline{Q}$ 69. La transition vers l'état haut est appliquée sur l'entrée SET 38 de la première bascule D 36, ce qui réarme automatiquement le circuit de commutation 30 après le temps de blocage.

Le calculateur comporte de plus un circuit de surveillance d'un circuit ouvert 80. Le circuit de surveillance d'un circuit ouvert 80 vise à détecter un courant d'alimentation Ia anormalement faible lorsque la fonction de commutation est activée, et donc un défaut de circuit ouvert.

Le circuit de surveillance d'un circuit ouvert 80 comporte un troisième amplificateur opérationnel 81. Une entrée non inverseuse du troisième amplificateur opérationnel 81 est reliée au point chaud de la résistance de mesure 32 via les résistances 53 et la capacité 54. Une entrée inverseuse du troisième amplificateur opérationnel 81 est connectée à un point P1. Le point P1 est relié via une résistance 83 et via la résistance 52 à la tension d'alimentation positive +Vcc. Le point P1 est aussi connecté à la masse électrique via une résistance 85 et une capacité 86 montées en parallèle. Une deuxième tension de référence Vref2 fixe et positive est donc appliquée sur l'entrée inverseuse. Une sortie du troisième amplificateur opérationnel 81 est reliée à une tension de +3,3V via une résistance 87. La sortie du troisième amplificateur opérationnel 81 produit un signal de défaut de circuit ouvert Sdco.

Lorsqu'un défaut de circuit ouvert survient, la tension de mesure Vmes aux bornes de la résistance de mesure 32 est anormalement basse, car le courant d'alimentation Ia est anormalement faible. La tension sur l'entrée non inverseuse du troisième amplificateur opérationnel 81, qui est une image de la tension de mesure Vmes, est donc inférieure à la deuxième tension de référence Vref2. La sortie du troisième amplificateur opérationnel 81 se trouve alors dans un état bas, ce qui permet au calculateur de détecter un défaut de circuit ouvert.

Le calculateur comporte de plus un circuit de surveillance et d'enregistrement 90 de l'état de la sortie discrète Sd. Le circuit de surveillance et d'enregistrement 90 vise à surveiller la cohérence de l'état de la sortie discrète Sd par rapport au signal d'activation de commutation Sac du circuit de commutation 30.

Le circuit de surveillance et d'enregistrement 90 comporte tout d'abord un quatrième amplificateur opérationnel 91. On note que le deuxième amplificateur opérationnel 51, le troisième amplificateur opérationnel 81 et le quatrième amplificateur opérationnel 91 sont intégrés dans un même composant.

Une entrée non inverseuse du quatrième amplificateur opérationnel 91 est reliée à la sortie discrète Sd via une résistance 92 et une capacité 93 montées en parallèle, et via une résistance 94. Deux diodes 95, 96 de même polarité sont montées en série. La cathode de la diode 95 est reliée à la tension d'alimentation positive +Vcc. L'anode de la diode 96 est reliée à la masse électrique. Un point P2 situé entre les deux diodes 95, 96 est relié à un point P3 situé entre la résistance 94 et la résistance 92.

Une entrée inverseuse du quatrième amplificateur opérationnel 91 est connectée à un point P4. Le point P4 est relié à la tension d'alimentation positive +Vcc via une résistance 97, et à la masse électrique via une résistance 98 et une capacité 99 montées en parallèle.

La sortie du quatrième amplificateur opérationnel 91 est reliée à une tension de +3,3V via une résistance 101.

Le quatrième amplificateur opérationnel 91 est alimenté uniquement par une tension négative -Vcc.

La sortie du quatrième amplificateur opérationnel 91 est par ailleurs reliée à une première entrée d'une première porte OU exclusif 102. Le signal d'activation de commutation Sac est appliqué sur la deuxième entrée de la première porte OU exclusif 102.

Une sortie de la première porte OU exclusif 102 est reliée, via un filtre passe-bas 103, à une première entrée d'une deuxième porte OU exclusif 104. Une deuxième entrée de la deuxième porte OU exclusif 104 est reliée à une masse électrique. Le filtre passe-bas 103 comporte deux résistances 106 et une capacité 107. La capacité 107 a une borne reliée à la masse électrique et une borne reliée à un point P5 situé entre les résistances 106.

Le circuit de surveillance et d'enregistrement 90 comporte en outre une deuxième bascule D 108. La première bascule D 36 et la deuxième bascule D 108 sont intégrées dans un même composant. La deuxième bascule D 108 comprend une entrée RESET 109, une entrée SET 110, une entrée Data 111, une entrée CLK 112, une sortie Q 113 et une sortie $\overline{Q}$ 114.

L'entrée Data 111 et l'entrée CLK 112 sont reliées à la masse électrique. La sortie $\overline{Q}$ 114 n'est pas connectée. La sortie SET 110 est reliée à une sortie de la deuxième porte OU exclusif 104. Un signal de défaut de ligne ouverte Sdlo est produit sur la sortie Q 113. Lorsque la sortie Q 113 est à l'état haut, un défaut de ligne ouverte est détecté. Un signal d'effacement du défaut Sed est appliqué, lorsque le défaut de ligne ouverte est corrigé, sur l'entrée RESET 109.

Lorsque la fonction de commutation est activée et que la ligne n'est pas défectueuse, le potentiel au niveau de la sortie discrète Sd du calculateur est relativement élevé. La première entrée de la première porte OU exclusif 102 et la deuxième entrée de la première porte OU exclusif 102 sont donc dans un état haut, et donc la sortie de la première porte OU exclusif 102 est dans un état bas. La sortie de la deuxième porte OU exclusif 104 est aussi dans un état bas. La sortie Q 113 de la deuxième bascule D 108 est alors dans un état bas, ce qui signifie qu'aucun défaut de ligne ouverte n'est détecté.

Au contraire, lorsque la fonction de commutation est activée et que la ligne est défectueuse, le potentiel au niveau de la sortie discrète Sd du calculateur est relativement bas. La première entrée de la première porte OU exclusif 102 est dans un état bas et la deuxième entrée de la première porte OU exclusif 102 est dans un état haut, et donc la sortie de la première porte OU exclusif 102 est dans un état haut. La sortie de la deuxième porte OU exclusif 104 est aussi dans un état haut. La sortie Q 113 de la deuxième bascule D 108 est alors dans un état haut, ce qui signifie qu'un défaut de ligne ouverte est détecté.

Le filtre passe-bas 103 et l'utilisation de la deuxième porte OU exclusif 104 permettent d'effacer les transitoires, c'est-à-dire, en l'occurrence, la détection erronée de défauts de ligne ouverte due à des variations transitoires rapides de la tension au niveau de la sortie discrète Sd du calculateur.

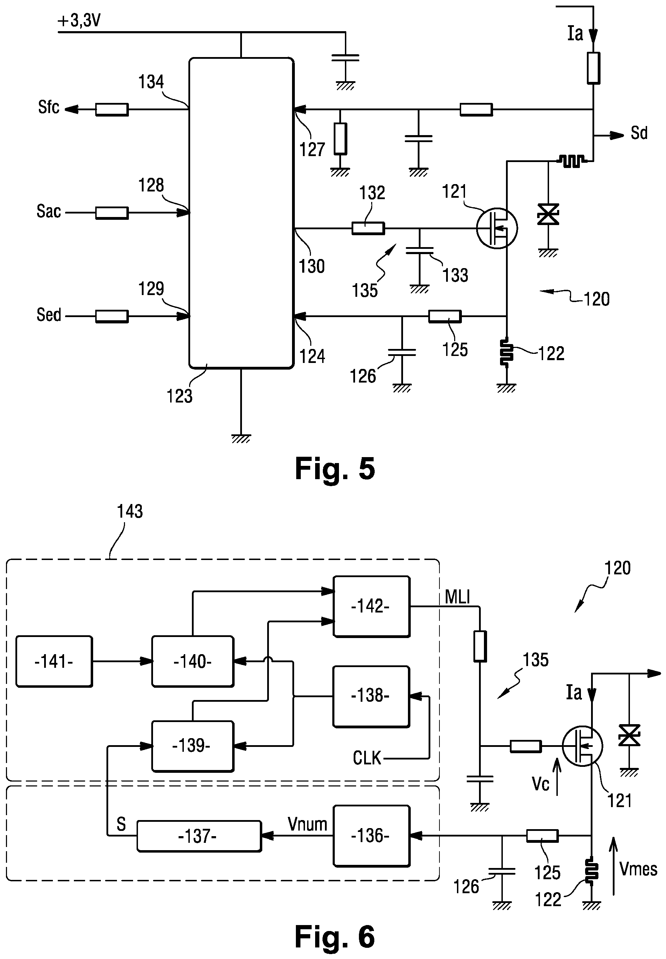

On décrit maintenant, en référence aux figures 5 et 6, un circuit de commutation selon un deuxième mode de réalisation de l'invention 120.

Le circuit de commutation 120 comporte à nouveau un transistor de puissance de type MOSFET 121 et une résistance de mesure 122.

Le circuit de commutation 120 comporte de plus un composant de pilotage destiné à la fois à commander le transistor 121 et à limiter le courant d'alimentation Ia. Le composant de pilotage est un composant numérique programmable. Le composant de pilotage est en l'occurrence un microcontrôleur 123, mais pourrait être un composant différent, par exemple un FPGA, un processeur, un ASIC, etc.

Le microcontrôleur 123 intègre, en plus de ses fonctions de calcul, toutes les mémoires nécessaires (RAM, Flash et EEPROM), les interfaces (convertisseur analogique numérique, liaison série, discrets, etc.) et les fonctions de séquencement (base de temps, temporisateurs, chien de garde, etc.).

Le microcontrôleur 123 possède une entrée 124 reliée au point chaud de la résistance de mesure 122 via un filtre passe-bas comprenant une résistance 125 et une capacité 126. Le microcontrôleur 123 possède aussi une entrée 127 reliée à la sortie discrète Sd elle-même reliée au point froid de la charge à alimenter, une entrée 128 qui reçoit le signal d'activation de commutation Sac de la fonction de commutation, une entrée 129 qui reçoit le signal d'effacement de défaut Sed.

Le microcontrôleur 123 possède une sortie 130 reliée à la grille du transistor 121 via un filtre passe-bas 135 comprenant une résistance 132 et une capacité 133, ainsi qu'une sortie 134 fournissant un statut de la fonction de commutation Sfc.

Le microcontrôleur 123 est alimenté par une tension de +3,3V.

La mise en oeuvre du circuit de commutation 120 utilise un convertisseur analogique numérique 136, un module de calcul 137, un compteur 138, un premier comparateur 139, un deuxième comparateur 140, un registre 141, et une bascule RS 142. Le compteur 138 est un compteur 10 bits, et le registre 141 contient des données ayant une taille de 10 bits.

Le convertisseur analogique numérique 136 acquiert la tension de mesure Vmes, et produit une tension de mesure numérique Vnum sur 10 bits.

Le module de calcul 137 produit, à partir de la tension de mesure numérique Vnum, un signal d'erreur numérique S sur 10 bits.

Le signal d'erreur numérique S est tel que :

$$S = 1023 - (Vnum - C) * G.$$

Dans cette formule, 1023 correspond à la pleine échelle de codage analogique numérique sur 10 bits. Le signal d'erreur numérique S est ainsi centré dans la dynamique du signal numérique en sortie du convertisseur analogique numérique 136.

Dans cette formule, C est une valeur de consigne de tension correspondant à une consigne de courant d'alimentation Ia égale au seuil de courant prédéfini. G est un gain qui amplifie la différence entre la tension de mesure numérique Vnum et la consigne de tension C.

Ici, C=205 (ce qui correspond à une consigne de tension de 1V sur Vmes) et G=8, et donc :

$$S = 1023 - (Vnum - 205) * 8.$$

La sortie du module de calcul 137, sur 10 bits, est reliée une première entrée du premier comparateur 139.

Le compteur 138, quant à lui, reçoit un signal d'horloge CLK et compte les fronts montants du signal d'horloge CLK. Le compteur 138 forme un registre de valeurs numériques représentatives d'une rampe formant une fonction triangulaire.

La sortie du compteur 138 est reliée à une deuxième entrée du premier comparateur 139.

Lorsque le signal d'erreur numérique S est égal à la valeur numérique du compteur 138, la sortie du premier comparateur 139 passe dans un état haut.

La sortie du premier comparateur 139 est reliée à une entrée S de la bascule RS 142. Ainsi, lorsque le signal d'erreur numérique S est égal à la valeur numérique du compteur 138, une sortie Q de la bascule 142 change d'état. La remise à l'état initial de la bascule RS 142 est assurée en fin de rampe.

Le premier comparateur 139, le compteur 138 et la bascule RS 142 forment donc un premier générateur de signal par modulation de largeur d'impulsion (signal MLI) 143, programmé dans le microcontrôleur 123. Le signal MLI est produit au niveau de la sortie Q de la bascule 142. Le rapport cyclique du signal MLI dépend du signal d'erreur numérique S.

Le filtre passe-bas 135 produit une tension de commande continue Vc égale à une moyenne du signal MLI. La tension de commande continue Vc est appliquée sur la grille du transistor 121.

Le filtre passe-bas 135 joue donc un double rôle. Le filtre passe-bas 135 filtre le signal MLI pour produire la tension de commande continue Vc. Le filtre passe-bas 135 garantit la stabilité de la boucle de régulation en produisant une coupure du premier ordre selon une fréquence suffisamment basse pour que la boucle de régulation n'ait plus assez de gain pour être instable lorsque la rotation de phase est suffisante.

On note que le registre 141 contient ici la valeur hexadécimale FF. Cette valeur, comparée par le deuxième comparateur 140 avec la sortie du compteur 138, conditionne la fréquence maximale du signal MLI. Cette valeur peut être modifiée dynamiquement selon les conditions de fonctionnement du circuit de commutation 120.

On retrouve les trois modes de fonctionnement qui ont été décrits plus tôt.

Le premier mode de fonctionnement est utilisé lorsque la charge ne doit pas être alimentée. Dans ce cas, le signal d'activation de commutation Sac est tel que la fonction de commutation n'est pas activée. La sortie de la bascule RS 142 est dans un état bas, et le transistor 121 est dans un état bloqué.

Dans le deuxième mode de fonctionnement, la charge doit être alimentée. Le signal d'activation de commutation Sac est tel que la fonction de commutation est activée. Dans le deuxième mode de fonctionnement, la charge est telle que le courant d'alimentation la ne peut atteindre le seuil de courant prédéfini. Dans ce cas, la tension de commande continue Vc est telle que le transistor 121 se trouve en régime saturé.

Dans le troisième mode de fonctionnement, la charge doit être alimentée. Le signal d'activation de commutation Sac est tel que la fonction de commutation est activée. Dans le troisième mode de fonctionnement, la charge est telle que le courant d'alimentation la peut atteindre le seuil de courant prédéfini. Dans ce cas, la tension de commande continue Vc est telle que le transistor 121 se trouve en régime linéaire.

Outre la mise en œuvre de la fonction de commutation et de la fonction de limitation, le microcontrôleur 123 met en œuvre de manière numérique et pilote l'ensemble des circuits qui ont été décrits plus tôt : circuit de désarmement 50, circuit de réarmement automatique 60, circuit de surveillance d'un circuit ouvert 80, circuit de surveillance et d'enregistrement 90.

L'utilisation du microcontrôleur 123 permet de réaliser l'ensemble des fonctions décrites ci-dessus tout en étant facilement paramétrable par configuration logicielle. La solution utilisant le microcontrôleur 123 est donc moins encombrante et plus simple matériellement que la solution discrète du premier mode de réalisation de l'invention. Le coût récurrent est aussi minimisé car le microcontrôleur 123 (ou tout autre composant numérique programmable) est un composant à très bas coût.

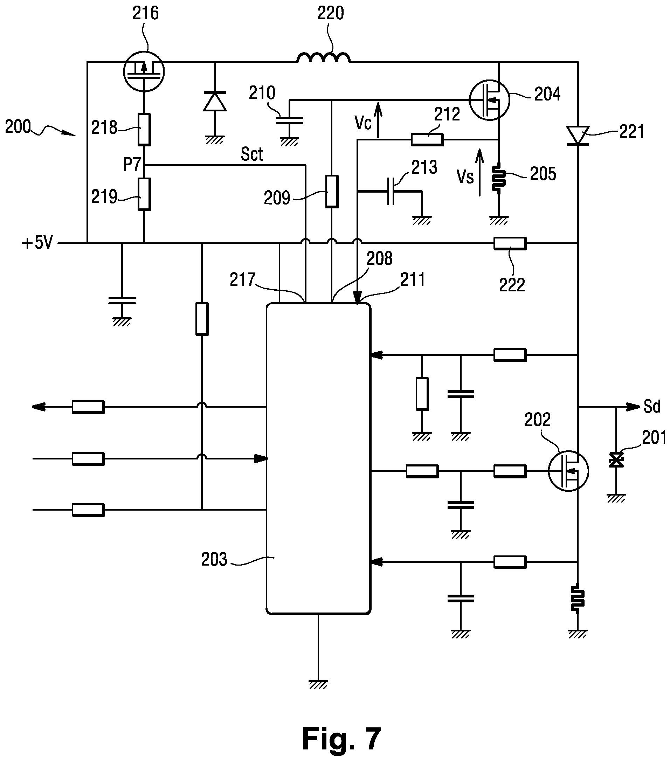

Avantageusement, en référence aux figures 7 à 9, on met aussi en œuvre un circuit de surveillance 200 d'un composant de protection contre la foudre.

Le composant de protection est ici une diode transil 201. La diode transil 201 présente une borne qui est reliée au drain du transistor 202 du circuit de commutation, et une borne qui est reliée à la masse électrique.

La défaillance que vise à détecter le circuit de surveillance 200 est une défaillance en mode « coupé » : la diode transil 201 forme alors un circuit ouvert.

Le circuit de surveillance 200 est piloté par un composant de pilotage, en l'occurrence par un microcontrôleur 203 qui pilote aussi le circuit de commutation ainsi que l'ensemble des circuits décrits plus tôt. Le microcontrôleur 203 comporte des entrées et des sorties semblables à celles du microcontrôleur 123.

Le circuit de surveillance 200 comporte un premier transistor 204 et une résistance de surveillance 205. Le premier transistor 204 est un transistor de type N-MOSFET

La résistance de surveillance 205 est connectée entre le premier transistor 204 et la masse électrique. Une sortie de surveillance 208 du microcontrôleur 203 est reliée à la grille du premier transistor 204 via une résistance 209 et une capacité 210 montées en parallèle. Une entrée de mesure 211 du microcontrôleur 203 acquiert, via une résistance 212 et une capacité 213 montées en parallèle, une tension de surveillance Vs aux bornes de la résistance de surveillance 205.

Un convertisseur analogique numérique 215 intégré dans le microcontrôleur 203 mesure et numérise la tension de surveillance Vs.

Le circuit de surveillance 200 comporte en outre un deuxième transistor 216, de type P-MOSFET. Une sortie de commande 217 du microcontrôleur 203 est connectée à un point P7. Le point P7 est situé entre une résistance 218 et une résistance 219. La résistance 218 est reliée à la grille du deuxième transistor 216. Le drain du deuxième transistor 216 est relié à une tension de +5V. La source du deuxième transistor 216 est connectée à une première borne d'une inductance 220. La deuxième borne de l'inductance 220 est reliée au drain du premier transistor 204. Le drain du premier transistor 204 est aussi relié à l'anode d'une diode 221, dont la cathode est connectée à la sortie discrète Sd du calculateur et à la diode transil 201. La cathode de la diode 221 est aussi reliée à la tension de +5V via une résistance 222.

Le principe de fonctionnement du circuit de surveillance 200 consiste, lorsqu'il convient de tester la diode transil 201, à générer une tension de test Vt supérieure à une tension de limitation de la diode transil 201 et à appliquer la tension de test Vt aux bornes de la diode transil 201. On compare alors la tension résultante aux bornes de la diode transil 201 avec la tension de limitation de la diode transil 201, et on détecte une défaillance de la diode transil 201 lorsque la tension résultante est supérieure à la tension de limitation.

Il convient cependant d'assurer que la tension résultante aux bornes de la diode transil 201 ne soit pas trop importante, et qu'elle ne soit pas susceptible de détruire les composants du calculateur, et notamment les composants du circuit de commutation (incluant le microcontrôleur 203).

Pour générer la tension de test Vt, le circuit de surveillance 200 comporte des moyens d'élévation de tension agencés pour générer la tension de test Vt et pour appliquer sélectivement la tension de test aux bornes de la diode transil 201.

Les moyens d'élévation de tension comprennent le deuxième transistor 216 et l'inductance 220. La tension de test Vt est appliquée sur la diode transil 201 via la diode 221.

Lorsqu'il convient de générer la tension de test Vt, un signal de commande de test Set est appliqué sur la grille du deuxième transistor 216.

Le circuit de surveillance 200 comporte aussi des moyens d'asservissement agencés pour asservir la tension résultante aux bornes de la diode transil 201 de manière à assurer que la tension résultante ne dépasse pas un seuil de tension maximale prédéterminée. On assure ainsi que la tension résultante n'est pas susceptible de détruire les composants du calculateur.

Les moyens d'asservissement comportent le premier transistor 204, la résistance de surveillance 205 et le microcontrôleur 203.

Le microcontrôleur 203 est destiné à générer une tension de commande Vc du premier transistor 204 et à asservir une tension de surveillance Vs aux bornes de la résistance de surveillance 205 sur la tension de commande Vc.

La mise en oeuvre du circuit de surveillance 200 utilise le convertisseur analogique numérique 215 du microcontrôleur 203, un module de calcul 222, un compteur 223, un premier comparateur 224, un deuxième comparateur 225, un registre 226, et une bascule RS 227.

Le convertisseur analogique numérique 215 acquiert la tension de surveillance Vs, et produit une tension de surveillance numérique Vnum sur 10 bits.

Le module de calcul 222 produit, à partir de la tension de mesure numérique Vnum et du seuil de tension maximale prédéterminée, un signal d'erreur numérique S sur 10 bits.

Le signal d'erreur numérique S est tel que :

$$S = 1023 - (Vnum - C) * G.$$

Dans cette formule, 1023 correspond à la pleine échelle de codage analogique numérique sur 10 bits. Le signal d'erreur numérique S est ainsi centré dans la dynamique du signal numérique en sortie du convertisseur analogique numérique 215.

Dans cette formule, C est une valeur de consigne de tension correspondant à une consigne de courant. G est un gain qui amplifie la différence entre la tension de mesure numérique Vnum et la consigne de tension.

Le premier comparateur 224, le compteur 223 et la bascule RS 227 forment un deuxième générateur de signal par modulation de largeur d'impulsion (signal MLI) 230, programmé dans le microcontrôleur 203.

Le deuxième générateur de signal par modulation de largeur d'impulsion 230 fonctionne de manière semblable au premier générateur de signal par modulation de largeur d'impulsion 143 décrit plus tôt.

Un filtre passe-bas 228, formé par la résistance 209 et la capacité 210, produit une tension de commande continue Vc égale à une moyenne du signal MLI. La tension de commande continue Vc est appliquée sur la grille du premier transistor 204.

Le signal de commande de test Set est aussi appliqué en entrée de la bascule RS 227. Le signal de commande de test Set autorise donc la génération du signal MLI et donc de la tension de commande continue Vc.

On note que le registre 226 contient cette fois la valeur hexadécimale 17.

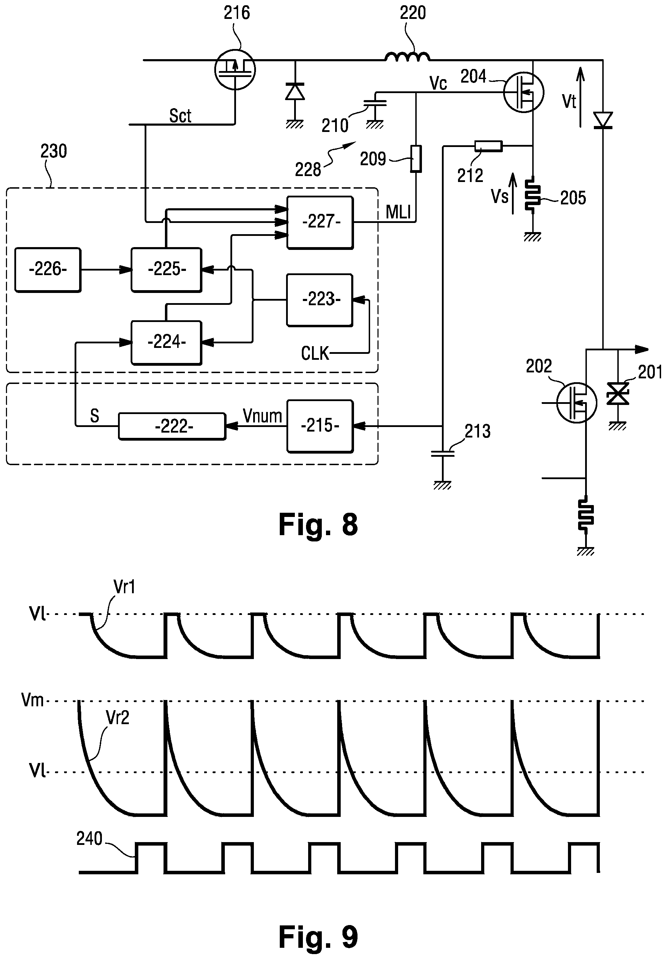

En référence à la figure 9, lorsque le signal de commande de test Set est dans un état haut, le deuxième générateur de signal par modulation de largeur d'impulsion 230 créé un signal carré 240 présentant une certaine période et un certain *duty cycle*.

Chaque état haut du signal carré ouvre le premier transistor 204. La tension de test Vt est alors générée par les moyens d'élévation de tension. Lorsque le signal carré 209 retourne à l'état bas, le premier transistor 204 passe dans un mode bloqué et la tension de test Vt s'écroule et s'annule, jusqu'à l'état haut suivant du signal carré 240.

Lorsque la diode transil 201 est fonctionnelle, la tension résultante Vr1 est limitée par une tension de limitation Vl de la diode transil 201.

Lorsque la diode transil 201 est défaillante et constitue un circuit ouvert, la tension résultante Vr2 est susceptible d'atteindre une valeur maximale beaucoup plus importante. La valeur maximale est cependant limitée au seuil de tension maximale prédéterminé Vm.

La régulation de la tension résultante Vr2 sur le seuil de tension maximale prédéterminé Vm est réalisée par le deuxième générateur de signal par modulation de largeur d'impulsion 230. La valeur de la consigne de courant C évoquée plus tôt est donc définie en fonction du seuil de tension maximale prédéterminé Vm et de la résistance de surveillance 205.

Le circuit de surveillance 200 comporte des moyens de détection agencés pour comparer la tension résultante aux bornes de la diode transil 201 avec la tension de limitation Vl de la diode transil 201, et à détecter une défaillance de la diode transil 201 lorsque la tension résultante est supérieure à la tension de limitation Vl. Les moyens de détection sont implémentés dans le microcontrôleur 203.

Lorsque le seuil de tension maximale prédéterminé Vm est atteint par la tension résultante Vr2, les moyens de détection du microcontrôleur 203 détectent que la tension résultante Vr2 est supérieure à la tension de limitation Vl, et détectent donc que la diode transil 201 forme un circuit ouvert et est défaillante.

On note que le comportement de cette fonction de surveillance est dépendant de la charge utilisatrice. Il est donc préférable de réaliser la surveillance lorsqu'aucune charge n'est connectée à la sortie discrète du calculateur, ce qui correspond généralement aux phases de fabrication et de vérification avant la mise en service du calculateur. Même s'il peut s'avérer nécessaire de limiter la mise en oeuvre de la fonction de surveillance à ces phases, la fonction de surveillance demeure très intéressante pour réduire les coûts de fabrication et de maintien en conditions opérationnelles.

Bien entendu, l'invention n'est pas limitée aux modes de réalisation décrits mais englobe toute variante entrant dans le champ de l'invention telle que définie par les revendications.

Tous les circuits et toutes les fonctions présentés ici peuvent être mis en oeuvre de manière numérique ou analogique.

## Revendications

1. Circuit de commutation destiné à commuter à une masse électrique un point froid d'une charge (22) dont un point chaud est relié à un réseau d'alimentation, le circuit de commutation comportant un transistor (23 ; 31 ; 121) monté entre le point froid et la masse électrique, une résistance de mesure (24 ; 32 ; 122) montée entre le transistor et la masse électrique, et un composant de pilotage destiné à la fois à commander le transistor et à limiter un courant d'alimentation (Ia) fourni à la charge (22) par le réseau d'alimentation, le composant de pilotage étant agencé pour recevoir une tension de commande ($V_H$) formant un signal de connexion ou un signal de déconnexion du point froid et de la masse électrique, et pour :

   - lorsque la tension de commande ($V_H$) est un signal de déconnexion, générer une tension de pilotage ($V_p$) qui commande le transistor dans un état bloqué ;
   - lorsque la tension de commande ($V_H$) est un signal de connexion et que le courant d'alimentation (Ia) ne peut pas atteindre un seuil de courant prédéfini, générer une tension de pilotage ($V_p$) qui commande le transistor en régime saturé ;
   - lorsque la tension de commande ($V_H$) est un signal de connexion et que le courant d'alimentation (Ia) peut atteindre le seuil de courant prédéfini, générer une tension de pilotage ($V_p$) qui commande le transistor en régime linéaire, de sorte que le courant d'alimentation soit régulé pour ne pas dépasser le seuil de courant prédéfini.

2. Circuit de commutation selon la revendication 1, dans lequel le composant de pilotage est un amplificateur opérationnel (26 ; 33) qui a une entrée inverseuse reliée à un point chaud de la résistance de mesure, une entrée non inverseuse sur laquelle est appliquée la tension de commande ($V_H$), et une sortie sur laquelle est générée la tension de pilotage ($V_p$).

3. Circuit de commutation selon la revendication 2, dans lequel, lorsque le transistor est commandé en régime linéaire, une tension de mesure (Vmes) aux bornes de la résistance de mesure est asservie par l'amplificateur opérationnel sur la valeur de la tension de commande ($V_H$).

4. Circuit de commutation selon la revendication 1, le composant de pilotage étant un composant de traitement de type microcontrôleur (123 ; 203) dans lequel un premier générateur de signal par modulation de largeur d'impulsion (143) est programmé.

5. Circuit de commutation selon la revendication 4, dans lequel le premier générateur de signal par modulation de largeur d'impulsion (143) comporte un comparateur (139), un compteur (138) et une bascule RS (142), une sortie de la bascule RS (142) étant reliée, via un filtre passe-bas (135), à une grille du transistor.

6. Circuit de commutation selon la revendication 5, comportant un convertisseur analogique numérique (136) qui numérise une tension de mesure (Vmes) aux bornes de la résistance de mesure, et un module de calcul (137) qui produit un signal d'erreur numérique (S) à partir d'une tension de mesure numérique (Vnum) et du seuil de courant prédéfini, le signal d'erreur numérique étant appliqué en entrée du comparateur (139) qui compare le signal d'erreur numérique avec une valeur du compteur (138) .

7. Circuit de commutation selon la revendication 1, le circuit de commutation comportant en outre un circuit de surveillance (200) d'un composant de protection contre la foudre (201).

8. Circuit de commutation selon la revendication 7, dans lequel le circuit de surveillance (200) est agencé pour générer une tension de test (Vt) aux bornes du composant de protection contre la foudre (201), et pour comparer une tension aux bornes du composant de protection contre la foudre (201) avec une tension de limitation (Vl) du composant de protection contre la foudre (201).

9. Circuit de commutation selon la revendication 7, dans lequel le circuit de surveillance (200) comprend un composant de traitement de type microcontrôleur (203) dans lequel un deuxième générateur de signal par modulation de largeur d'impulsion (230) est programmé.

10. Circuit de commutation selon la revendication 7, dans lequel le composant de protection contre la foudre (201) est une diode transil.

11. Circuit de commutation selon la revendication 1, comprenant en outre un circuit de désarmement (50) agencé pour produire le signal de déconnexion lorsqu'une tension de mesure (Vmes) aux bornes de la résistance de mesure est supérieure à une tension de référence.

**12.** Circuit de commutation selon la revendication 11, comprenant en outre un circuit de réarmement automatique (60) comprenant un premier multivibrateur monostable (61) et un deuxième multivibrateur monostable (62).

**13.** Calculateur comprenant un circuit de commutation selon l'une des revendications précédentes et une sortie discrète reliée au circuit de commutation.

Fig. 1

Fig. 2

**Fig. 3**

**Fig. 4**

**Fig. 5**

**Fig. 6**

**Fig. 7**

**Fig. 8**

**Fig. 9**